# EUROPEAN PATENT SPECIFICATION

(11) **EP 2 399 340 B1**
(45) Date of publication and mention of the grant of the patent: **02.01.2013**
(21) Application number: 10705432.2
(22) Date of filing: 16.02.2010
(51) Int. Cl.: H03K 5/04, H03K 5/13, H03K 5/159, H03K 5/06

(54) **PULSE-SHRINKING DELAY LINE BASED ON FEED FORWARD**
AUF FEED-FORWARD BASIERENDE IMPULSSENKENDE VERZÖGERUNGSLEITUNGEN
LIGNE DE RETARD À RÉTRÉCISSEMENT D'IMPULSION BASÉE SUR UNE CORRECTION AVAL

(30) Priority: 17.02.2009 EP 09290114
(43) Date of publication of application: 28.12.2011
(60) Divisional application: 12177008.5
(73) Proprietor: NXP B.V., 5656 AG Eindhoven (NL)
(72) Inventor: CRESPO, Denis, NL-5656 AE Eindhoven (NL); Dufour, Yves, NL-5656 AE Eindhoven (NL); MARIE, Herve, NL-5656 AE Eindhoven (NL)
(74) Representative: Schouten, Marcus Maria
(86) International application number: PCT/IB2010/050691
(87) International publication number: WO 2010/095095

(56) References cited:
- US-A1- 2003 234 671
- US-A1- 2004 041 608
- US-A1- 2007 047 689
- US-A1- 2008 238 652
- US-B1- 6 278 638

## Description

### FIELD OF THE INVENTION

The invention relates to an electronic circuit comprising a digital delay line with a cascade of a plurality of stages configured for modifying a width of a pulse propagating down the cascade.

### BACKGROUND ART

Delay lines are well-known components and are used in, e.g., delay-locked loops (DLLs) and in time-to-digital converters (TDCs). DLLs are typically used for generating time-shifted clocks. The TDC is a key block for measuring timing differences between two clock signals. The TDC, in particular, is a key block of a digital PLL, such as the one needed in multi-gigahertz radio applications.

Digital delay lines are often made as a cascade of CMOS inverter stages. The binary signal propagates from the cascade's input to the cascade's output, and each stage delays the occurrence of the signal's edges by a specific amount of time.

In a TDC, the digital delay line used is typically of the type that changes the signal's pulse-width while the pulse is propagating along the cascade. This delay line has a cascade of stages, each of which implements a longer delay for the propagation of one of the pulses edges, e.g., the rising edge, than for the other edge of the pulse, e.g., the falling edge. This configuration shrinks or widens the width of the signal's pulse to a further extent at each stage. A stage is implemented as, e.g., a pair of CMOS inverters arranged in series. For an example of a known pulse-shrinking delay line see, e.g., Tisa S, Lotito A, Giudice A & Zappa F (2003) "Monolithic time-to-digital converter with 20ps resolution"; Proc. European Solid-State Circuits Conference, ESSCIRC'03, Estoril, Portugal, pp. 465-468.

There is a variety of approaches to obtaining a shrinking or widening of the pulse width. One approach is to select the ratios of the sizes of the transistors for the different stages so as to determine how fast a falling edge and how fast a rising edge propagates. For example, if the width of the p-type field effect transistor (FET) of the i-th inverter in the cascade is denoted by Wₚᵢ and the width of the n-type FET in the i-th inverter as Wₙᵢ, then shrinking occurs between the input of inverter₍ᵢ₎ and the output of inverter₍ᵢ₊₎ if the ratio Wₚ₍ᵢ₊₁₎/Wₙ₍ᵢ₊₁₎ is smaller than the ratio Wₚ₍ᵢ₎/Wₙ₍ᵢ₎. Another approach is to bias the gates of one or more transistor per stage. For more information see, e.g., US patent 6,288,587.

### SUMMARY OF THE INVENTION

The inventors propose an a pulse shrinking delay line, i.e., a delay line that modifies the signal's pulse width, with a configuration that enables to obtain a higher time resolution than the conventional pulse shrinking delay lines. That is, the delay line of the invention can be configured to operate with shorter delays.

To this end, the inventors propose an electronic circuit comprising a digital delay line with a cascade of a plurality of stages. Each specific one of the stages has an input and an output and a main path between the input and the output. The main path has a first inverter and a second inverter connected in series via an intermediate node. Each specific stage has a third inverter between the input and the intermediate node of a downstream one of the stages in the cascade. Each specific stage has a fourth inverter between the intermediate node and the output of the downstream stage.

In effect the cascaded main paths in the circuit of the invention represent a pulse-width changing configuration known in the art, e.g., using proper ratios of the transistor widths as mentioned above. The third and fourth inverters implement a feed-forward mechanism that serves to pre-charge the inputs of the relevant inverters downstream of the specific stage, thus accelerating the propagation of the pulse down the cascade. Note that the feed-forward path connects nodes in the delay line that functionally lie an odd number of inverting operations apart.

In a further embodiment of a circuit according to the invention the first inverter is formed by a first transistor having its main channel connected between a first supply voltage and the intermediate node, and having a control electrode connected to the input. The second inverter is formed by a second transistor having its main channel connected between the output and a second supply voltage, and having its control electrode connected to the intermediate node. The third inverter is formed by a third transistor having its main channel connected between the second supply voltage and the intermediate node of the downstream stage, and having its control electrode connected to the input. The fourth inverter is formed by a fourth transistor having its main channel connected between the first supply voltage and the output of the downstream stage, and having its control electrode connected to the intermediate node. In this embodiment, the pulse's edge of a first polarity is given a reduced propagation time as a result of only keeping the feed-forward transistors assisting in faster propagating this edge. The edge of the other polarity is propagated only via the main path and is not subjected to a feed-forward operation.

The inventors have found that, even when the transistors of the inverters in above embodiment have equal size or width throughout the cascade, pulse-width modification occurs during propagation along the cascade. This embodiment has the advantage that the design and lay-out is simplified, and that moreover, for a pulse-shrinking configuration, this embodiment offers the best ratio of the shrinking delay to propagation delay. It is preferred that the propagation delay is low as this reduces the conversion time in, e.g., a TDC embodiment of the invention, so that the digital information is available at the output earlier; the noise level is lower since the time uncertainty associated with the delay action is more or less proportional to the propagation delay. Accordingly, for a given shrinking delay, it is preferred to have the lowest propagation delay. Furthermore, this embodiment has advantages in that the lay-out is smaller than when using full-fledged inverters, and in that the loads per inverter are minimized, thus leading to a further reduction of the propagation delays. As a result, a better resolution is obtained for still shorter time periods.

Above embodiments relate to a single-ended pulse-shrinking delay lines. The same principle can be applied to differential pulse-shrinking delay lines. The feed-forward paths should then similarly be connected between nodes that functionally lie an odd number of inverting operations apart.

For completeness, a feed-forward mechanism in a delay line is mentioned in the description of Figs. 10 and 11 of US 2007/0047689. However, the delay line is not of the type that modifies the signal's pulse-width as the pulse is propagating down the delay line, and the specific connections are not detailed.

Dokument US 2004/0041608 A1 discloses in figures 25, 26 a pulse generating circuit related to a conventional art.

### BRIEF DESCRIPTION OF THE DRAWING

The invention is explained in further detail, by way of example and with reference to the accompanying drawing, wherein:
Fig. 1 is a block diagram of an embodiment of a pulse-shrinking delay line in the invention;
Fig. 2 is a diagram illustrating the shrinking of a positive pulse propagating down the delay line of Fig. 1;
Fig. 3 is a diagram of another embodiment of a pulse-shrinking delay line in the invention;
Figs. 4 and 5 are transistor diagrams of implementations of the delay line in Fig. 1; and

Throughout the Figures, similar or corresponding features are indicated by same reference numerals.

### DETAILED EMBODIMENTS

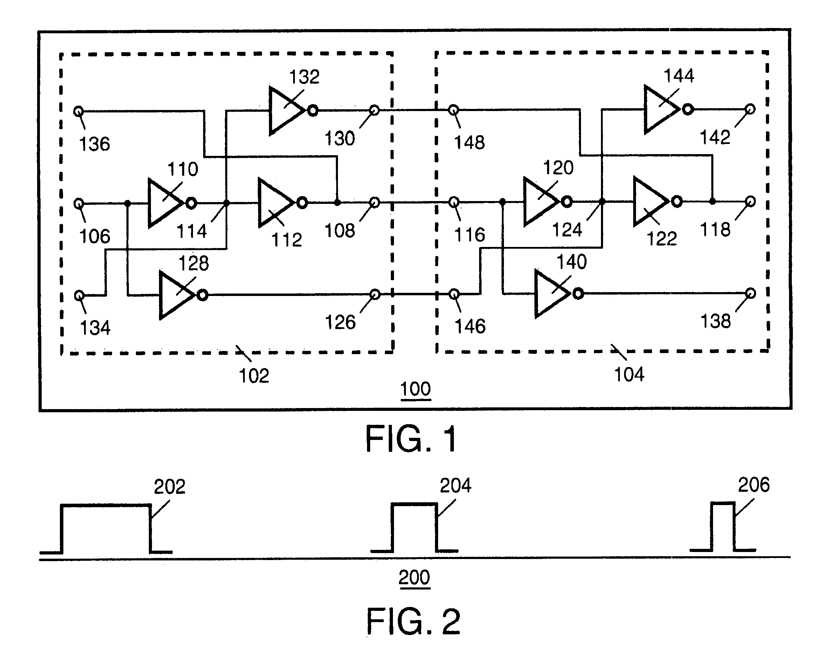

Fig. 1 is a diagram showing an electronic circuit 100 with a digital pulse-shrinking delay line with a cascade of a plurality of stages. For clarity, only stages 102 and 104 have been indicated. Stage 102 has a first input 106 and a first output 108 and a main path between first input 106 and first output 108. The main path has a first inverter 110 and a second inverter 112 connected in series via an intermediate node 114. Stage 104 has a first input 116 and a first output 118 and a main path between first input 116 and first output 118. The main path has a first inverter 120 and a second inverter 122 connected in series via an intermediate node 124. Each of stages 102 and propagates the rising edge and the falling edge of a pulse at the relevant first input to the relevant output.

Stage 102 has a second output 126 and a third inverter 128 between first input 106 and second output 126; a third output 130 and a fourth inverter 132 between intermediate node 114 and third output 130; a second input 134 connected to intermediate node 114; and a third input 136 connected to first output 108. Likewise, stage 104 has a second output 138 and a third inverter 140 between first input 116 and second output 138; a third output 142 and a fourth inverter 144 between intermediate node 124 and third output 142; a second input 146 connected to intermediate node 124; and a third input 148 connected to first output 118. Stage 104 has first input 116 connected to first output 108 of preceding stage 102, second input 146 connected to second output 126 of preceding stage 102 and third input 148 connected to third output 130 of preceding stage 102.

The cascaded main paths formed by inverters 110, 112, 120 and 122 represent a pulse-width changing configuration known in the art, if the inverters propagate the rising edge of a pulse and the falling edge of the pulse with different delays. This is brought about in conventional shrinking delay lines by, e.g., different biasing of the inverters or different dimension ratios of adjacent inverters per stage, as mentioned above. Additional inverters 128 and 132, used in the invention, implement a feed-forward mechanism. Inverter 128 serves to pre-charge intermediate node 124 that is the input to inverter 122, and inverter 132 serves to pre-charge the first input of the stage (not shown) that succeeds stage 104. The pre-charging causes the transitions of the signal pulse, i.e., the rising edges and falling edges, to be speeded up, and as a result brings about the shrinking of the width of the pulse while it propagates down the cascade.

Fig. 2 is a diagram 200 illustrating the operation of circuit 100. It is assumed that stages 102 and 104 form part of a longer delay line of which the other stages have not been shown. A pulse 202 at input 106 is modified by stage 102 into a pulse 204 at output 108. Pulse 204 appears at input 116 and is modified by stage 104 into a pulse 206 at output 118. As the edges of pulse 202 are fed-forward to stage 104, stage 104 causes the edges of pulse 204 to be subjected to a shorter time-shift than without the use of the feed-forward path. As a consequence the width of pulse 206 becomes smaller than the width of pulse 204. Note that in the invention, inverters 110, 112, 120 and 122 can be uniform in the sense of using the same bias or same dimension ratio throughout, in contrast with the conventional pulse shrinking delay line. In the invention, the shrinking operation is carried out by inverters 128, 132, 140 and 144 that implement the feed-forward path.

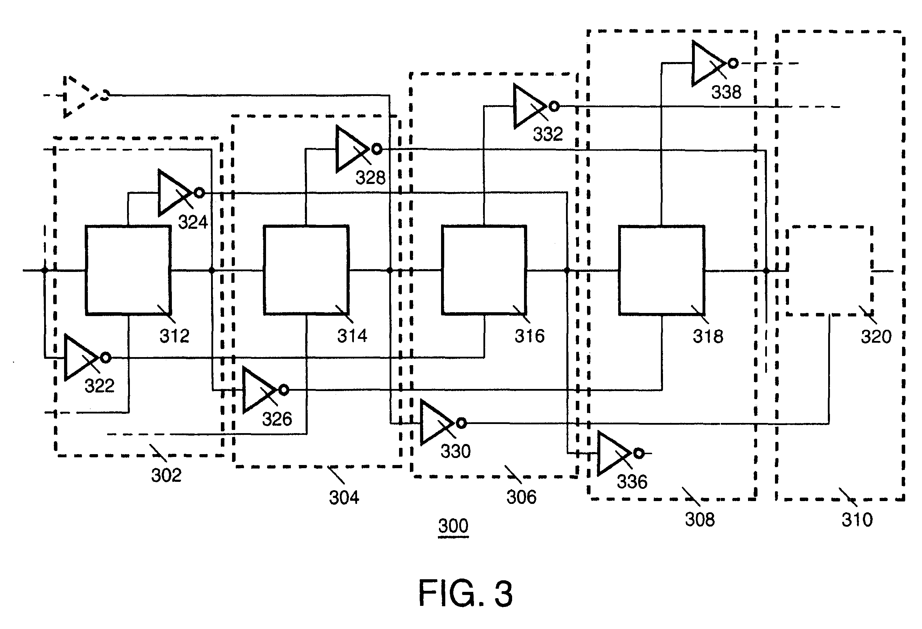

Fig. 3 is a diagram of a circuit 300 illustrating a variation on the theme of the invention. In circuit 100, additional inverters 128, 132, 140 and 144 are located in the feed-forward paths to the stage immediately succeeding the stage accommodating the additional inverters. In circuit 300, the feed-forward paths connect a specific stage to a downstream one of the stages further downstream than the stage immediately succeeding the specific stage.

More specifically, circuit 300 comprises a pulse-shrinking delay line with a plurality of cascaded stages, of which only stages 302, 304, 306, 308 and 310 have been indicated. The main path of the delay line is formed by a cascade of modules 312, 314, 316, 318 and 320, each comprising a series arrangement of inverting gates, not shown in order to not obscure the drawing. Circuit 300 comprises additional inverters 332, 324, 326, 328, 330, 332, 334, 336 and 338 to form feed-forward paths between stages 302-310. Note that the feed-forward path connecting one stage to a next one, located downstream the cascade, skips a stage in between. For example, additional inverters 322 and 324 of stage 302 connect to stage 306, skipping stage 304. Instead of skipping a single stage, one could design pulse-shrinking delay lines wherein the feed-forward paths skip more than one stage.

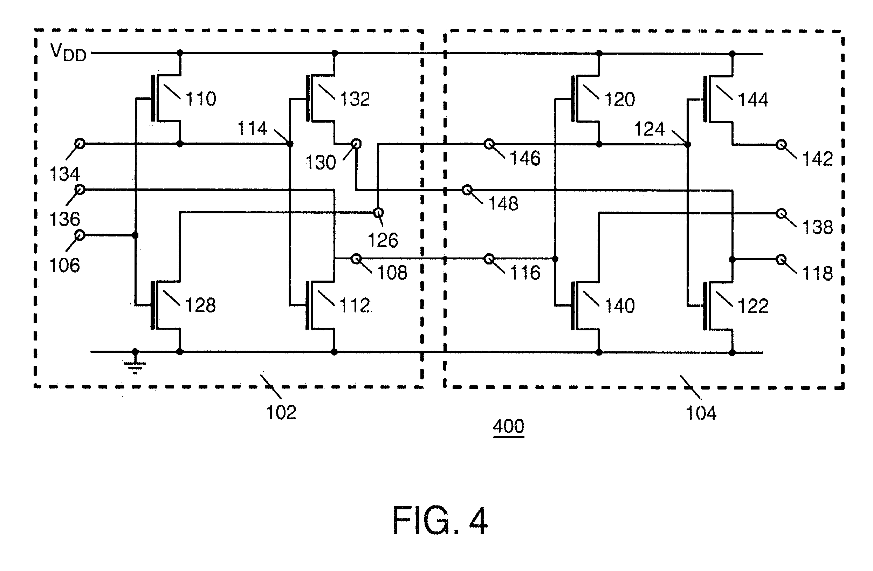

Fig. 4 is a transistor implementation 400 of stages 102 and 104 in circuit 100 discussed above, created with field effect transistors (FETs) in, e.g., CMOS. Conventionally, a CMOS inverter is formed by connecting the main current channels of a PFET and an NFET in series between a first supply voltage (here: V_{DD}) and a second supply voltage (here signal-ground). The control electrodes of the PFET and NFET are connected and form the inverter's input. The inverter's output is formed by a node between the main channels. Implementation 400 causes the shrinking of a *negative* pulse: the rising edge of the input pulse propagates faster than the falling edge of the input pulse. In implementation 400, each of inverters 110, 112, 128 and 132 of circuit 100 is reduced to a single transistor, either a PFET or an NFET, and only those transistors have been kept that help to reduce the propagation delay of the signal's rising edge. The transistors in Fig. 4 have been given the same reference numerals as the corresponding inverters of circuit 100. Transistors 110 and 132 are PFETs, and transistors 128 and 112 are NFETs in this example. Because the load on each node is minimized, the propagation delay is further reduced as compared to an implementation with full-fledged two-FET inverters.

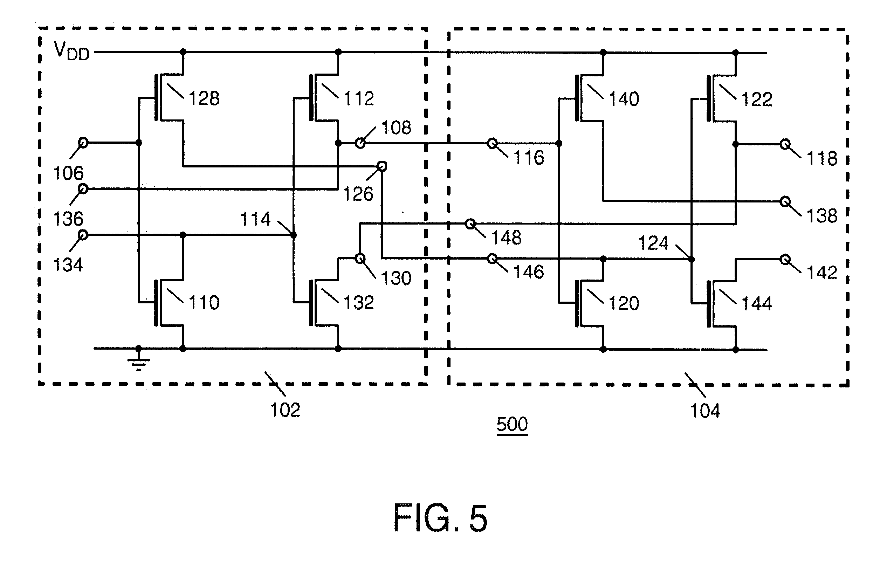

Fig. 5 is another transistor implementation 500 of stages 102 and 104 in circuit 100 discussed above, created with FETs. In a sense, implementation 500 is a mirror image of implementation 400. Implementation 500 is operative to cause the shrinking of a *positive* pulse: the falling edge of the input pulse propagates faster than the rising edge of the input pulse.

The inventors have carried out simulations for a shrinking-pulse delay line of cascaded stages with each a series connection of two conventional CMOS inverters, and for a shrinking-pulse delay line of cascaded stages each of which configured as implementation 300 made in a 65nm CMOS process for a supply voltage of 1.2 Volts at a temperature of 47° Celsius. The targeted shrinking delay Δt was set to 10 ps (10⁻¹¹ seconds). The delay TP_{H} per stage for a rising edge was found to be 33 ps for the conventional stage and 19 ps for the stage in the invention. The delay TP_{L} per stage for a falling edge was found to be 43 ps for the conventional stage and 29 ps for a stage in the invention.

Accordingly, in comparison to the conventional approach, the invention provides a shorter delay per stage, lower power consumption, and lower susceptibility of the operation to the transistor sizes used.

In above embodiments, the cascade of stages uses inverters. It is clear that other logic gates can be used that implement an inverting operation, e.g., a NOR gate or a NAND gate. These latter gates can be biased at one of their inputs so as to functionally implement an inverter, or the additional input terminals can be used to control the pulse propagating down the cascade by applying control signals thereto.

## Claims

1. An electronic circuit (100) comprising a digital delay line with a cascade of a plurality of stages (102, 104) configured for modifying a width of a pulse propagating down the cascade, wherein:
- each specific one of the stages has an input (106; 116) and an output (108; 118) and a main path between the input and the output;
- the main path has a first inverter (110; 120) and a second inverter (112; 122) connected in series via an intermediate node (114; 124);
- each specific stage has a third inverter (128; 140) connected between the input and the intermediate node of a downstream one of the stages in the cascade; **characterized in that**;
- each specific stage has a fourth inverter (132; 140) connected between the intermediate node of the specific stage and the output of the downstream stage.

2. The circuit of claim 1, wherein the downstream stage is adjacent the specific stage.

3. The circuit of claim 1, wherein:
- the first inverter (110) is formed by a first transistor (110) having its main channel connected between a first supply voltage and the intermediate node (114), and having a control electrode connected to the input (114);
- the second inverte (112) is formed by a second transistor (112) having its main channel connected between the output and a second supply voltage, and having its control electrode connected to the intermediate node (114);
- the third inverter (128) is formed by a third transistor (128) having its main channel connected between the intermediate node (124) of the downstream stage (104) and the second supply voltage, and having its control electrode connected to the input; and
- the fourth inverter (132) is formed by a fourth transistor (132) having its main channel connected between the first supply voltage and the output of the downstream stage (104) and having its control electrode connected to the intermediate node (114).

4. The circuit of claim 3, wherein the first, second, third and fourth transistors have equal widths.

## Patentansprüche

1. Ein elektronischer Schaltkreis (100), welcher eine digitale Verzögerungsleitung mit einer Kaskade einer Mehrzahl von Stufen (102, 104) aufweist, welche konfiguriert sind zum Modifizieren einer Breite eines Pulses, welcher die Kaskade herunter propagiert, wobei:
- jede Spezifische der Stufen einen Eingang (106, 116) und einen Ausgang (108, 118) und einen Hauptpfad zwischen dem Eingang und dem Ausgang hat,
- der Hauptpfad einen ersten Inverter (110, 120) und einen zweiten Inverter (112, 122) hat, welche über einen Zwischenknoten (114, 124) in Reihe verbunden sind,
- jede spezifische Stufe einen dritten Inverter (128, 140) hat, welcher zwischen den Eingang und den Zwischenknoten einer Nachgelagerten der Stufen in der Kaskade verbunden ist, **dadurch gekennzeichnet, dass**
- jede spezifische Stufe einen vierten Inverter (132, 140) hat, welcher zwischen den Zwischenknoten der spezifische Stufe und den Ausgang der nachgelagerten Stufe verbunden ist.

2. Der Schaltkreis gemäß Anspruch 1, wobei die nachgelagerte Stufe angrenzend an die spezifische Stufe ist.

3. Der Schaltkreis gemäß Anspruch 1, wobei:
- der erste Inverter (110) mittels eines ersten Transistors (110) gebildet ist, welcher seinen Hauptkanal zwischen eine erste Versorgungsspannung und den Zwischenknoten (114) verbunden hat und eine Steuerelektrode hat, welche mit dem Eingang (114) verbunden ist, der zweite Inverter (112) mittels eines zweiten Transistors (112) gebildet ist, welcher seinen Hauptkanal zwischen den Ausgang und eine zweite Versorgungsspannung verbunden hat und seine Steuerelektrode mit dem Zwischenknoten (114) verbunden hat,
der dritte Inverter (128) mittels eines dritten Transistors (128) gebildet ist, welcher seinen Hauptkanal zwischen den Zwischenknoten (124) der nachgelagerten Stufe (104) und die zweite Versorgungsspannung verbunden hat und seine Steuerelektrode mit dem Eingang verbunden hat, und
der vierte Inverter (132) mittels eines vierten Transistors (132) gebildet ist, welcher seinen Hauptkanal zwischen die ersten Versorgungsspannung und den Ausgang der nachgelagerten Stufe (104) verbunden hat und seine Steuerelektrode mit dem Zwischenknoten (114) verbunden hat.

4. Der Schaltkreis gemäß Anspruch 3, wobei der erste, zweite, dritte und vierte Transistor gleiche Breiten haben.

## Revendications

1. Circuit électronique (100) comprenant une ligne à retard numérique avec une cascade d'une pluralité d'étages (102, 104) configurés de manière à modifier une largeur d'une impulsion se propageant à travers la cascade, dans lequel :
- chaque étage particulier parmi les étages a une entrée (106 ; 116) et une sortie (108 ; 118) et un trajet principal entre l'entrée et la sortie ;
- le trajet principal contient un premier inverseur (110 ; 120) et un deuxième inverseur (112 ; 122) raccordés en série par l'intermédiaire d'un noeud intermédiaire (114 ; 124) ;
- chaque étage particulier contient un troisième inverseur (128 ; 140) raccordé entre l'entrée et le noeud intermédiaire d'un des étages en aval dans la cascade ; **caractérisé par le fait que**
- chaque étage particulier contient un quatrième inverseur (132 ; 140) raccordé entre le noeud intermédiaire de l'étage particulier et la sortie de l'étage en aval.

2. Circuit selon la revendication 1, dans lequel l'étage en aval est l'étage adjacent de l'étage particulier.

3. Circuit selon la revendication 1, dans lequel :
- le premier inverseur (110) est formé d'un premier transistor (110) ayant son canal principal raccordé entre une première tension d'alimentation et le noeud intermédiaire (114), et ayant une électrode de commande raccordée à l'entrée (114) ;
- le deuxième inverseur (112) est formé d'un deuxième transistor (112) ayant son canal principal raccordé entre la sortie et une deuxième tension d'alimentation, et ayant son électrode de commande raccordée au noeud intermédiaire (114) ;
- le troisième inverseur (128) est formé d'un troisième transistor (128) ayant son canal principal raccordé entre le noeud intermédiaire (124) de l'étage en aval (104), et la deuxième tension d'alimentation, et ayant son électrode de commande raccordée à l'entrée ; et
- le quatrième inverseur (132) est formé d'un quatrième transistor (132) ayant son canal principal raccordé entre la première tension d'alimentation et la sortie de l'étage en aval (104), et ayant son électrode de commande raccordée au noeud intermédiaire (114).

4. Circuit selon la revendication 3, dans lequel le premier, le deuxième, le troisième et le quatrième transistor ont des largeurs égales.
